# EUROPEAN PATENT SPECIFICATION

(11) **EP 1 612 300 B1**
(45) Date of publication and mention of the grant of the patent: **26.05.2010**
(21) Application number: 04015358.7
(22) Date of filing: 30.06.2004
(51) Int. Cl.: C30B 29/40, C30B 29/38, C30B 9/00

(54) **Method for producing a single crystal of AlN.**
Verfahren zur Herstellung eines AlN-Einkristalles
Procédé pour la production d'un monocristal de AlN

(43) Date of publication of application: 04.01.2006
(73) Proprietor: Sumitomo Electric Industries, Ltd., Osaka-shi, Osaka 541 (JP)
(72) Inventor: Uematsu, Koji, Sumitomo Electric Industries, Ltd., Itami-shi Hyogo (JP); Nakahata, Seiji Sumitomo Electric Industries, Ltd., Itami-shi Hyogo (JP)
(74) Representative: Grünecker, Kinkeldey, Stockmair & Schwanhäusser Anwaltssozietät

(56) References cited:
- FR-A- 2 796 657
- US-A- 6 066 205
- US-A1- 2003 168 003
- US-A1- 2003 211 369
- US-B1- 6 562 124
- KAWAMURA F ET AL: "GROWTH OF A LARGE GAN SINGLE CRYSTAL USING THE LIQUID PHASE EPITAXY (LPE) TECHNIQUE" JAPANESE JOURNAL OF APPLIED PHYSICS, PUBLICATION OFFICE JAPANESE JOURNAL OF APPLIED PHYSICS. TOKYO, JP, vol. 42, no. 1A/B, PART 2, 15 January 2003 (2003-01-15), pages L04-L06, XP001191978 ISSN: 0021-4922
- PATENT ABSTRACTS OF JAPAN vol. 0092, no. 78 (C-312), 6 November 1985 (1985-11-06) & JP 60 122797 A (TOSHIBA KK), 1 July 1985 (1985-07-01)
- MOTOYUKI TANAKA: J.JAPANESE ASSOCIATION FOR CRYSTAL GROWTH, vol. 25, no. 4, 1998, pages 163-166, XP008038881 JP

## Description

### BACKGROUND OF THE INVENTION

### Field of the Invention

The present invention relates to a nitride single crystal and a producing method thereof, and more particularly to a nitride single crystal and a producing method of the nitride single crystal employing liquid-phase sintering for its growth.

### Description of the Background Art

Nitride semiconductors such as AlN and Si₃N₄ have attracted attention for use as light emitting devices emitting visible or ultraviolet light, and as electronic devices operating at high voltage and large current. Although a material such as sapphire or silicon carbide has been employed for a substrate for producing such an electronic device, it is difficult to form a favorable epitaxial wafer due to large lattice mismatch and a large difference in thermal expansion coefficient between the material and the nitride semiconductor. As such, a nitride substrate ensuring lattice match with the nitride semiconductor has been desired for improvement of properties of the electronic device.

Normally, sublimation, vapor-phase growth or melting is used for growth of a single crystal. It however is difficult to grow a single crystal of nitride such as AlN or Si₃N₄ by melting, since the nitride has a low decomposition temperature and requires a high temperature and a high pressure to increase the decomposition temperature higher than a melting temperature. As such, vapor-phase growth or sublimation is used to grow a single crystal of the nitride.

In vapor-phase growth, AlN (g) is generated from the reaction of 2Al (s) + 2NH₃ (g) → 2AlN (g) + 3H₂ (g), and is precipitated as a single crystal. It however is difficult to obtain a large single crystal, since Al as the raw material is highly reactive, making it difficult to control the reaction.

Further, in sublimation, for example, aluminum nitride is sublimated and decomposed and then recombined and recrystallized to obtain a single crystal. With this method, again, it is difficult to obtain a large single crystal, since the crystal growth rate at the time of recrystallization is slow (see the article by Motoyuki Tanaka, titled "Growth of AlN Single Crystal by the Sublimation Method", Journal of Japanese Association for Crystal Growth, Japanese Association for Crystal Growth, 1998, Vol. 25, No. 4, pp. 163-166).

**U-A-6 066 205** describes a method of growing bulk single crystals of aluminum nitride (AlN) from a melt by injecting a nitrogen-containing gas into liquid aluminum at elevated temperatures and pressure. A seed crystal that is maintained at a temperature below that of the surrounding liquid aluminum is pulled from the melt, while the AlN that is formed in the melt is deposited on the seed crystal. As an alternative to injection of a nitrogen-containing gas, nitrogen may be supplied to the melt in a solid nitrogen containing compound, eg an AlN pellet. JP-A-60122797 teaches producing a large-sized AlN single crystal by adding alkaline earth metallic oxide to AlN and melting the mixture by heating then cooling slowly the melt.

On the other hand, in fabrication of polycrystalline aluminum nitride widely used as a heat dissipation substrate for an electronic component, liquid-phase sintering is used to make a small crystal grow larger to thereby improve properties, such as thermal conductivity and others, of the product

### SUMMARY OF THE INVENTION

An object of the present invention is to solve the above-described problems and provide a nitride single crystal large in size and a producing method thereof.

To achieve the object, the inventors have completed the present invention by applying liquid-phase sintering, having conventionally been used exclusively for production (sintering) of a polycrystalline nitride, to a producing method of a nitride single crystal.

Specifically, the method of producing a nitride single crystal according to the present invention includes the steps of : forming a material transport medium layer containing a compound of rare earth element on a surface of an AlN crystal; and making a seed crystal in contact with the material transport medium layer to grow a AlN single crystal on the seed crystal. It is preferable that the material transport medium layer contains the compound of rare earth element and at least one compound selected from a group of aluminum compound, alkaline earth compound and transition metal compound, and/or that each of the compounds is an oxide or an oxinitride.

With this producing method, a nitride single crystal having a crystal size of at least 10 mm can be obtained.

As described above, according to the present invention, it is possible to form a nitride single crystal of a large crystal size by forming a material transport medium layer containing a compound of rare earth element on a surface of a nitride crystal and by making a seed crystal in contact with the material transport medium layer to grow a nitride single crystal on the seed crystal.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a conceptual diagram of a producing method of a nitride single crystal according to the present invention.
Figs. 2A and 2B are conceptual diagrams illustrating liquid-phase sintering.
Fig. 3 illustrates an embodiment of the producing method of a nitride single crystal according to the present invention.

### DESCRIPTION OF THE PREFERRED EMBODIMENTS

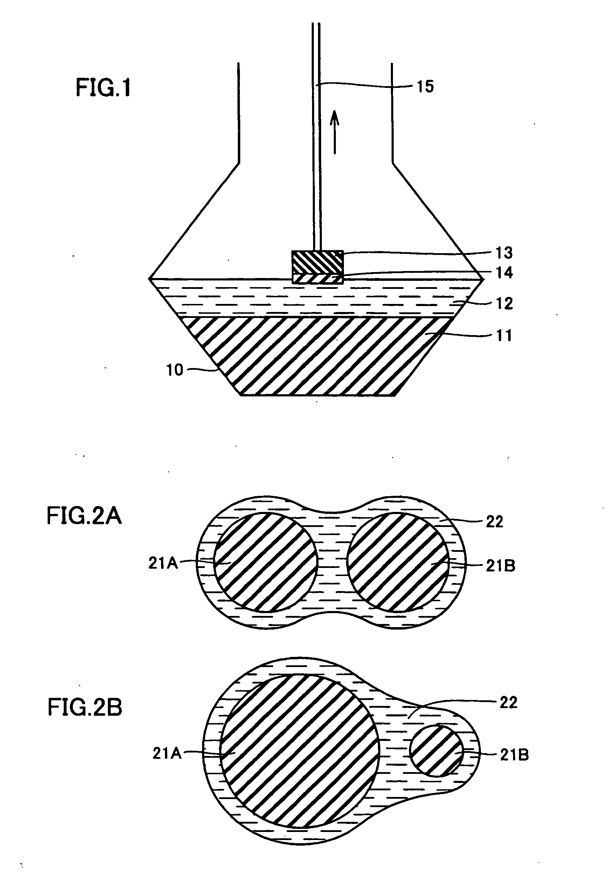

Referring to Fig. 1, the producing method of a nitride single crystal according to the present invention includes the step of forming a material transport medium layer 12 containing a compound of rare earth element on a surface of a nitride crystal 11, and the step of making a seed crystal 13 in contact with material transport medium layer 12 to grow a nitride single crystal 14 on seed crystal 13.

For example, when a mixture of aluminum nitride (AlN) powder as the nitride crystals and yttrium oxide (Y₂O₃) powder as the compound of rare earth element is heated to a high temperature, Y₂O₃ melts and forms the material transport medium for AlN. More specifically, when the powder of the nitride crystals and the powder containing the compound of rare earth element are mixed and heated to a high temperature, a liquid-phase material transport medium layer 22 containing the rare earth element compound is formed on surfaces of nitride crystals 21A, 21B, as shown in Fig. 2A. The nitride moves from one nitride crystal 21B to the other nitride crystal 21A via material transport medium layer 22 over time, as shown in Fig. 2B, resulting in growth of nitride crystal 21 A.

Here, if the other nitride crystal is replaced with a nitride single crystal as a seed crystal and the growth conditions are adjusted, then it is possible to grow a nitride single crystal on the seed crystal. For example, as shown in Fig. 1, nitride crystals 11 and powder containing a compound of rare earth element are introduced into a crucible 10 and heated to form a material transport medium layer 12 on the surfaces of nitride crystals 11. A seed crystal 13 is then pulled, while kept in contact with material transport medium layer 12, so that a nitride single crystal 14 grows on seed crystal 13.

It is noted that the nitride crystal 11 for use as the raw material of nitride single crystal 14 is not limited to the nitride powder. A nitride sintered body, nitride polycrystalline body, or nitride polymorphic body may be used as well. A large nitride single crystal can be obtained using any of these nitride crystals.

The producing method of a nitride single crystal according to the present invention has wide applications, including pulling methods (e.g., Czochralski (CZ) method, liquid encapsulated Czochralski (LEC) method), vertical boat methods (e.g., vertical Bridgeman (VB) method), and horizontal boat methods (e.g., horizontal Bridgeman (HB) method), as long as the process of making a seed crystal in contact with a material transport medium layer to grow a nitride single crystal on the seed crystal is employed.

Although the mixing ratio of the powder containing a compound of rare earth element with respect to the nitride crystal is not limited specifically, the ratio (powder containing the rare earth element compound / nitride crystal) is preferably from 0.1 to 10 in mass ratio to ensure that the material transport medium layer covers the nitride crystal sufficiently and with high concentration. If the mass ratio is less than 0.1, coverage of the nitride crystal with the material transport medium layer is insufficient. If it exceeds 10, the concentration of the nitride within the material transport medium layer decreases. In either case, the crystal growth rate decreases. Based on the foregoing, the ratio of the powder containing the rare earth element compound to the nitride crystal is more preferably from 0.5 to 5.

Here, the rare earth element is a generic name for 17 elements of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

The temperature for forming the material transport medium layer and growing the nitride single crystal is preferably from 1800°C to 2800°C. If it is lower than 1800°C, formation of the material transport medium layer of liquid phase is difficult. If it exceeds 2800°C at a pressure of 1013 hPa, decomposition of the nitride begins. The temperature is more preferably from 1800°C to 2000°C from the standpoint of cost reduction.

In the producing method of a nitride single crystal according to the present invention, the material transport medium layer preferably contains a compound of rare earth element, and at least one compound selected from a group consisting of aluminum compound, alkaline earth compound and transition metal compound. Heating the compound such as aluminum compound together with the compound of rare earth element can decrease the temperature for formation of the material transport medium layer and increase the material transport efficiency of the material transport medium layer, and thus, the growth rate of the single crystal also increases.

Although the content ratio of the at least one compound selected from a group of aluminum compound, alkaline earth compound and transition metal compound with respect to the compound of rare earth element is not limited specifically, the ratio (at least one compound selected from the relevant group / compound of rare earth element) is preferably from 0.1 to 10 and more preferably from 0.2 to 2 in mass ratio, from the standpoint of lowering the melting point.

Further, a complex compound of a compound of rare earth element and at least one compound selected from a group of aluminum compound, alkaline earth compound and transition metal compound may also be used suitably. A preferable example thereof is a compound oxide of aluminum oxide (Al₂O₃) and yttrium oxide (Y₂O₃).

In the producing method of a nitride single crystal according to the present invention, the compound is preferably an oxide or an oxinitride. When the compound is an oxide or an oxinitride, it is readily possible to form a homogeneous material transport medium layer.

The nitride single crystal according to the present invention is obtained with the producing method as described above. With the producing method, it is possible to obtain a large nitride single crystal having a crystal size of at least 10 mm.

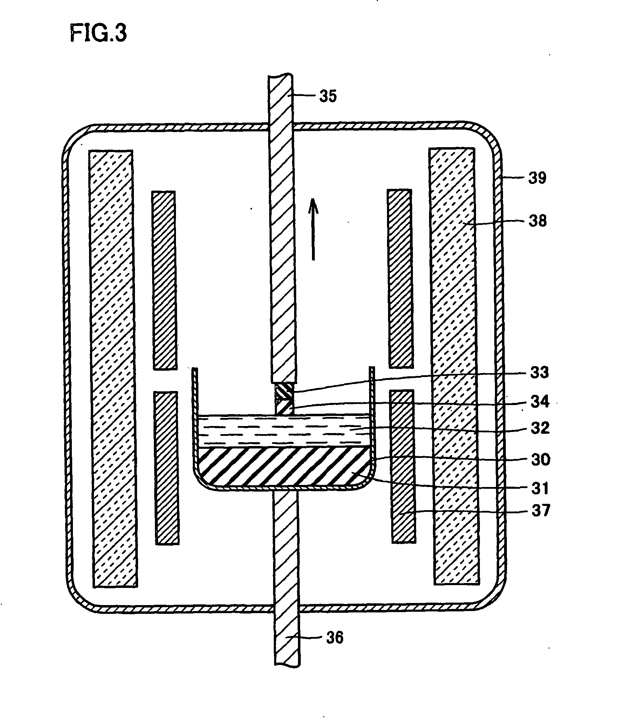

A specific example of application of the present invention to the pulling method is now described with reference to Fig. 3. As shown in Fig. 3, the apparatus for producing a nitride single crystal by pulling has a crucible 30, and a heater 37 and a heat insulating material 38 and others surrounding crucible 30, arranged in a stainless container 39. The apparatus further has a pulling shaft 35 for pulling a seed crystal 33 that is kept in contact with a melt (a material transport medium layer 32 in the present invention) within crucible 30.

### (Example 1)

AlN powder as nitride crystals 31, in an amount of 1000 g, and Y₂O₃ powder as the powder for formation of liquid-phase material transport medium layer 32, in an amount of 1000 g, were mixed and introduced into crucible 30. With the pressure within the apparatus held at 1013 hPa, the temperature was increased to 1900°C to melt the Y₂O₃ powder to thereby form material transport medium layer 32. Thereafter, an AlN single crystal as seed crystal 33 was pulled by 10 mm over 200 hours, while kept in contact with material transport medium layer 32, in synchronization with the growth rate of a product 34 growing on seed crystal 33. X ray diffraction (XRD) was conducted to evaluate product 34 grown on seed crystal 33, and it was found to be an AlN single crystal. The results are shown in Table 1.

### (Examples 2-10)

For each of Examples 2-10, the ingredients shown in Table 1 including material(s) for forming the material transport medium layer were mixed and heated to the temperature as shown in Table 1, to grow a product 34 on seed crystal 33 in the same manner as in Example 1. X ray diffraction (XRD) was conducted to evaluate product 34 grown on seed crystal 33, and it was found to be an AlN single crystal. The results are shown in Table 1.

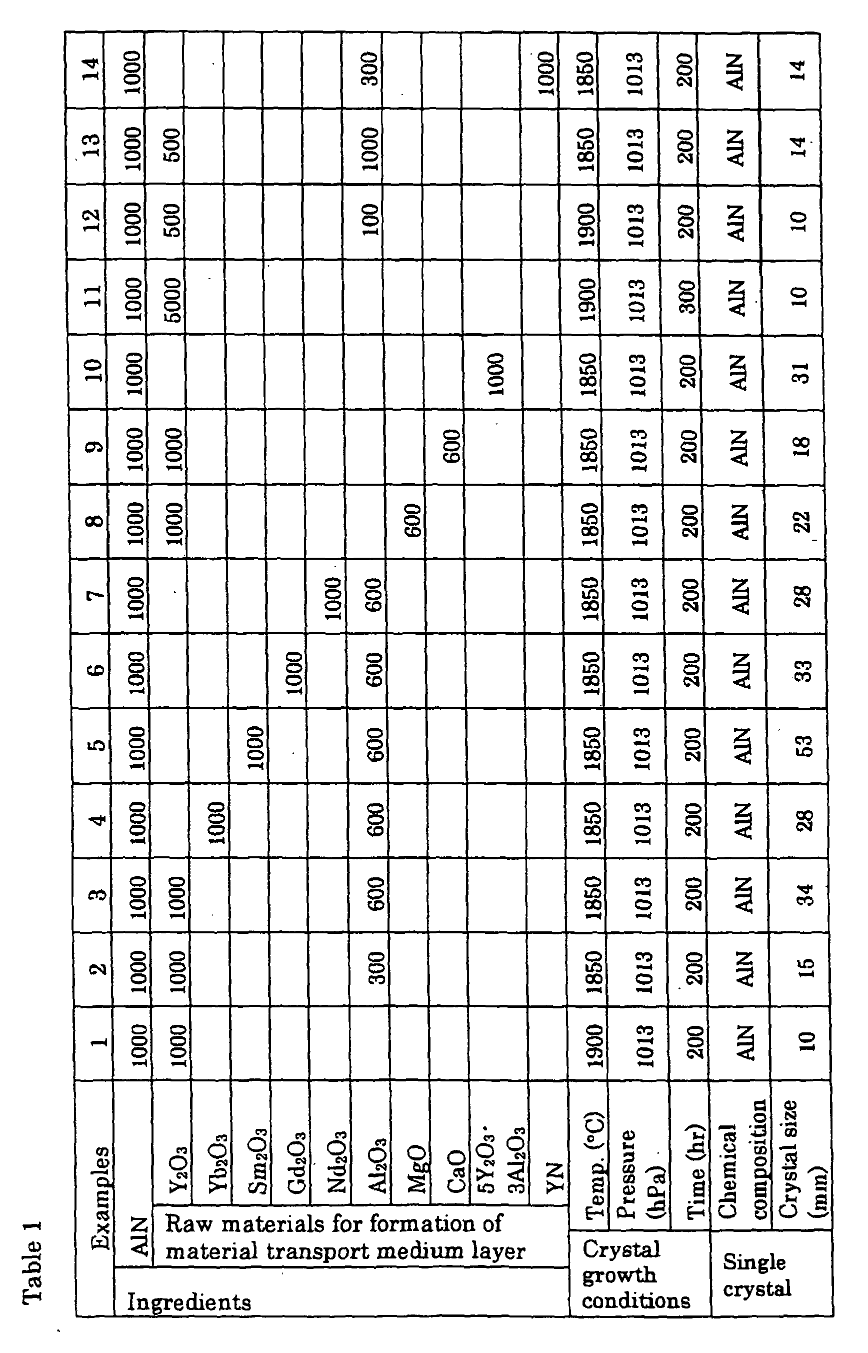

As shown in Table 1, a transparent AlN single crystal having a crystal size of at least 10 mm was obtained using the producing method of a nitride single crystal according to the present invention.

As shown in Examples 1-3, using Al₂O₃ together with Y₂O₃ as the raw materials for the material transport medium layer can increase the growth rate of the AlN single crystal, so that a larger single crystal is obtained.

As shown in Example 10, using only a compound oxide of rare earth element and aluminum as the raw material for the material transport medium layer can produce a similar effect as in the case of using the oxide of rare earth element and the oxide of aluminum (Example 3).

Further, as shown in Example 14, when a nitride of rare earth element and an oxide of aluminum are used as the raw materials for the material transport medium layer to form an oxinitride of rare earth element and aluminum, a material transport medium layer of favorable properties is formed, as in the case of forming an oxide of rare earth element and aluminum (Example 2), and thus, a large single crystal is obtained.

As described above, according to the present invention, it is possible to form a nitride single crystal having a large crystal size by forming a material transport medium layer containing a compound of rare earth element on a surface of a nitride crystal, and growing a nitride single crystal on a seed crystal that is kept in contact with the material transport medium layer.

## Claims

1. A method of producing an AIN single crystal, comprising the steps of:
forming a material transport medium layer (12) containing a compound of rare earth element on a surface of an AIN crystal (11); and
making a seed crystal (13) in contact with the material transport medium layer (12) to grow an AIN single crystal (14) on the seed crystal (13).

2. The method of producing an AIN single crystal according to claim 1, wherein said material transport medium layer (12) contains the compound of rare earth element and at least one compound selected from a group consisting of aluminum compound, alkaline earth compound and transition metal compound.

3. The method of producing an AIN single crystal according to claim 2,
wherein each of said compounds is an oxide or an oxynitride.

4. The method of producing an AIN single crystal according to claim 1,
wherein said compound is an oxide or an oxynitride.

## Patentansprüche

1. Verfahren zum Herstellen eines AIN-Einkristalls, das die folgenden Schritte umfasst:
Ausbilden einer Materialtransport-Medienschicht (12), die eine Verbindung eines Seltenerdelementes enthält, auf einer Oberfläche eines AlN-Kristalls (11); und
Erzeugen eines Keimkristalls (13) in Kontakt mit der Materialtransport-Medienschicht (12), um einen AIN-Einkristall (14) auf dem Keimkristall (13) zu züchten.

2. Verfahren zum Herstellen eines AIN-Einkristalls nach Anspruch 1, wobei die Materialtransport-Medienschicht (12) die Verbindung eines Seltenerdelementes und wenigstens eine Verbindung enthält, die aus einer Gruppe ausgewählt wird, die aus einer Aluminium-Verbindung, einer Erdalkali-Verbindung und einer Übergangsmetall-Verbindung besteht.

3. Verfahren zum Herstellen eines AlN-Einkristalls nach Anspruch 2,
wobei jede der Verbindungen ein Oxid oder ein Oxynitrid ist.

4. Verfahren zum Herstellen eines AIN-Einkristalls nach Anspruch 1,
wobei die Verbindung ein Oxid oder Oxynitrid ist.

## Revendications

1. Procédé de production d'un monocristal d'AIN comprenant les étapes consistant :
à former une couche de milieu de transport de matériau (12) contenant un composé d'élément de terre rare sur une surface d'un cristal d'AIN (11) ; et
à mettre un cristal de germe (13) en contact avec la couche de milieu de transport de matériau (12) pour faire croître un monocristal d'AIN (14) sur le cristal de germe (13).

2. Procédé de production d'un monocristal d'AIN selon la revendication 1, dans lequel ladite couche de milieu de transport de matériau (12) contient le composé d'élément de terre rare et au moins un composé choisi dans un groupe constitué d'un composé d'aluminium, d'un composé alcalino-terreux et d'un composé de métal de transition.

3. Procédé de production d'un monocristal d'AIN selon la revendication 2, dans lequel chacun desdits composés est un oxyde ou un oxynitrure.

4. Procédé de production d'un monocristal d'AIN selon la revendication 1, dans lequel ledit composé est un oxyde ou un oxynitrure.
